(19) **Europäisches Patentamt**
**European Patent Office**
**Office européen des brevets**

(11) **EP 3 054 463 B1**

(12) # EUROPEAN PATENT SPECIFICATION

(45) Date of publication and mention of the grant of the patent:
**02.09.2020 Bulletin 2020/36**

(51) Int Cl.:
*H01F 1/26* (2006.01)   *B22F 1/00* (2006.01)
*B22F 3/02* (2006.01)   *H01F 1/147* (2006.01)
*H05K 3/28* (2006.01)   *H05K 9/00* (2006.01)
*H05K 1/16* (2006.01)   *B22F 5/00* (2006.01)
*C22C 33/02* (2006.01)   *B22F 7/04* (2006.01)

(21) Application number: **14850354.3**

(22) Date of filing: **18.09.2014**

(86) International application number:
**PCT/JP2014/074637**

(87) International publication number:
**WO 2015/049992 (09.04.2015 Gazette 2015/14)**

(54) **SOFT MAGNETIC RESIN COMPOSITION AND SOFT MAGNETIC FILM**

WEICHMAGNETISCHE HARZZUSAMMENSETZUNG UND WEICHMAGNETISCHE FOLIE

COMPOSITION DE RÉSINE FAIBLEMENT FERROMAGNÉTIQUE, ET FILM FAIBLEMENT FERROMAGNÉTIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **01.10.2013 JP 2013206724**
**29.08.2014 JP 2014175884**

(43) Date of publication of application:
**10.08.2016 Bulletin 2016/32**

(73) Proprietor: **Nitto Denko Corporation**
**Ibaraki-shi, Osaka 567-8680 (JP)**

(72) Inventors:
- **EBE, Hirofumi**
**Ibaraki-shi, Osaka 567-8680 (JP)**
- **HABU, Takashi**
**Ibaraki-shi, Osaka 567-8680 (JP)**
- **MATSUTOMI, Akihito**
**Ibaraki-shi, Osaka 567-8680 (JP)**

- **MASUDA, Shotaro**
**Ibaraki-shi, Osaka 567-8680 (JP)**

(74) Representative: **Hoffmann Eitle**
**Patent- und Rechtsanwälte PartmbB**
**Arabellastraße 30**
**81925 München (DE)**

(56) References cited:
**EP-A1- 1 819 211         JP-A- H10 261 516**
**JP-A- 2006 135 136     JP-A- 2008 115 404**
**JP-A- 2009 059 753     JP-A- 2009 059 753**
**JP-B2- S6 258 631       US-A1- 2010 001 226**

- **YUICHI SATO ET AL.: 'Classification mechanism of an air classifier using centrifugal force (Part 3' JOURNAL OF THE SOCIETY OF POWDER TECHNOLOGY vol. 27, no. 4, 1990, JAPAN, pages 225 - 230, XP055331154**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

The present invention relates to a soft magnetic resin composition and a soft magnetic film obtained from the soft magnetic resin composition.

BACKGROUND ART

Recently, electronic devices such as personal computers and smartphones are equipped with functions of wireless communications and wireless power transmission. In electronic devices, for broadening distance of wireless communication, better efficiency, and a smaller size, a magnetic film for convergence of magnetic flux is disposed around an antenna or coil included in the electronic device (for example, see Patent Documents 1 and 3).

Patent Document 1 discloses a flexible magnetic film formed by blending flat soft magnetic powder with a binder.

Meanwhile, for improvement in convergence efficiency of magnetic flux, it is important to improve relative magnetic permeability (magnetic properties) of the magnetic film.

Thus, Patent Document 2 discloses an electromagnetic interference suppressor highly filled with soft magnetic particles by dispersing, as an ingredient material, soft magnetic powder to which a surface treatment is given by using a surface treatment agent containing Si elements.

Citation List

Patent Document

  Patent Document 1: Japanese Unexamined Patent Publication No. 2006-39947
  Patent Document 2: Japanese Unexamined Patent Publication No. 2005-310952
  Patent Document 3: Japanese Unexamined Patent Publication No. 2009-59753

SUMMARY OF THE INVENTION

PROBLEM TO BE SOLVED BY THE INVENTION

However, there are many voids generated inside the electromagnetic interference suppressor of Patent Document 2, therefore, the electromagnetic interference suppressor is insufficiently filled, and further improvement is required.

It is an object of the present invention to provide a soft magnetic resin composition enabling a soft magnetic film to be highly filled with soft magnetic particles and a soft magnetic film obtained from the soft magnetic resin composition.

MEANS FOR SOLVING THE PROBLEM

A soft magnetic resin composition of the present invention contains flat soft magnetic particles and a resin according to claim 1.

A soft magnetic film of the present invention is formed from the above-described soft magnetic resin composition.

It is preferable that the soft magnetic film of the present invention is produced by curing the soft magnetic resin composition by heating.

EFFECT OF THE INVENTION

The soft magnetic resin composition of the present invention contains the flat soft magnetic particles and the resin component, and the soft magnetic particles have a tap density of 1.1 g/cm$^3$ or less. Therefore, the soft magnetic film produced from the soft magnetic resin composition can contain the soft magnetic particles with a high filling rate and has excellent relative magnetic permeability.

DESCRIPTION OF EMBODIMENTS

1. Soft Magnetic Resin Composition

A soft magnetic resin composition of the present invention contains flat soft magnetic particles and a resin component.

Examples of a soft magnetic material of the soft magnetic particles include magnetic stainless steel (Fe-Cr-Al-Si alloy), Sendust (Fe-Si-Al alloy), Permalloy (Fe-Ni alloy), silicon copper (Fe-Cu-Si alloy), Fe-Si alloy, Fe-Si-B (-Cu-Nb) alloy, Fe-Si-Cr-Ni alloy, Fe-Si-Cr alloy, Fe-Si-Al-Ni-Cr alloy, and ferrite.

Among these, preferably, Sendust (Fe-Si-Al alloy) is used. More preferably, a Fe-Si-Al alloy having a Si content of 9 to 15 mass% is used. Use of these allows the soft magnetic film to have excellent magnetic permeability.

The soft magnetic particles are formed into flat (platy), that is, formed to have a small thickness and a wide plane. The soft magnetic particles have an aspect ratio of, for example, 8 or more, preferably 15 or more, and for example, 80 or less, preferably 65 or less. The aspect ratio is calculated, for example, as an aspect ratio by dividing the particle size $D_{50}$ (described later) of the soft magnetic particles with the average thickness of the soft magnetic particles.

The soft magnetic particles have an average particle size $D_{50}$ of, for example, 30 $\mu$m or more, preferably 50 $\mu$m or more, more preferably 60 $\mu$m or more, even more preferably 70 $\mu$m or more, and for example, 200 $\mu$m or less, preferably 100 $\mu$m or less, more preferably 80 $\mu$m or less. The average particle size $D_{50}$ of the soft magnetic particles within the above-described range allows for a magnetic film highly filled with the soft magnetic particles, and a thin soft magnetic film more excellently.

The average particle size $D_{50}$ is measured, for example, with a laser diffraction particle size distribution analyzer (manufactured by Sympatec, HELOS & RODOS).

The soft magnetic particles have a tap density of 1.1 g/cm$^3$ or less, preferably 1.0 g/cm$^3$ or less, more preferably 0.9 g/cm$^3$ or less, even more preferably 0.7 g/cm$^3$ or less, most preferably 0.6 g/cm$^3$ or less. The tap density within the above-described range allows the flat soft magnetic particles to be contained in the soft magnetic film with a high filling rate.

The lower limit of the tap density is, for example, 0.5 g/cm$^3$ or more.

The tap density can be measured with a tap density flowability and adhesion measuring apparatus ("Tap Denser KYT-4000", manufactured by SEISHIN ENTERPRISE Co., Ltd.).

The soft magnetic particles have a true specific density of, for example, 5.0 g/cm$^3$ or more, preferably 6.0 g/cm$^3$ or more, and for example, 8.0 g/cm$^3$ or less, preferably 7.0 g/cm$^3$ or less.

The soft magnetic particles can be produced by classifying known or commercially available soft magnetic particles with, for example, a classifier such as a dry classifier. To be specific, the soft magnetic particles can be produced by blowing air to the soft magnetic particles using a rotational vane of a dry classifier to exclude soft magnetic particles having a large tap density (for example, particles having a large aspect ratio and a large particle size), and collect soft magnetic particles having a small tap density.

The rotational vane has a rotational speed of, for example, 1000 rpm or more, preferably 1100 rpm or more, and for example, 3000 rpm or less, preferably 2500 rpm or less, more preferably 2300 rpm or less, even more preferably 2000 rpm or less.

The air flow rate is, for example, 1.0 m$^3$/min or more, preferably 1.2 m$^3$/min or more, and for example, 1.5 m$^3$/min or less, preferably 1.4 m$^3$/min or less.

The volume content of the soft magnetic particles in the soft magnetic resin composition (ratio in the solid content excluding solvent (that is, soft magnetic particles and resin component, and thermosetting catalyst and additional additive contained as necessary)) is, for example, 55% by volume or more, preferably 58% by volume or more, even more preferably 60% by volume or more, and for example, 95% by volume or less, preferably 90% by volume or less. The mass content thereof is, for example, 50 mass% or more, preferably 80 mass% or more, more preferably 85 mass% or more, and for example, 98 mass% or less, preferably 95 mass% or less. The volume content and the mass content of the soft magnetic particles within a range of the above-described upper limit or less allows for excellent film-forming characteristics of the soft magnetic resin composition into a film. Meanwhile, the volume content and the mass content of the soft magnetic particles within a range of the above-described lower limit or more allows for excellent magnetic properties of the soft magnetic film.

The resin component contains thermosetting resins.

Examples of the thermosetting resin include epoxy resin, phenol resin, amino resin, unsaturated polyester resin, polyurethane resin, silicone resin, urea resin, melamine resin, thermosetting polyimide resin, and diallyl phthalate resin. Epoxy resin and phenol resin are used in combination.

For the epoxy resin, for example, those which can be used as an adhesive composition can be used, including bisphenol epoxy resin (particularly, bisphenol A epoxy resin, bisphenol F epoxy resin, bisphenol S epoxy resin, brominated bisphenol A epoxy resin, hydrogenated bisphenol A epoxy resin, bisphenol AF epoxy resin, etc.), phenol epoxy resin (particularly, phenol novolak epoxy resin, ortho-cresol novolak epoxy resin, etc.), biphenyl epoxy resin, naphthalene epoxy resin, fluorene epoxy resin, trishydroxyphenylmethane epoxy resin, and tetraphenylolethane epoxy resin. Furthermore, for example, hydantoin epoxy resin, trisglycidylisocyanurate epoxy resin, and glycidylamine epoxy resin can be also used. These can be used singly, or can be used in combination of two or more.

Of these examples of the epoxy resin, preferably, bisphenol epoxy resin, or more preferably, bisphenol A epoxy resin is used. Containing the epoxy resin allows for excellent reactivity with the phenol resin, and as a result, the soft magnetic film has excellent heat resistance. It also allows for decrease in gaps in the soft magnetic film, and allows the soft magnetic film to be highly filled with the soft magnetic particles.

The phenol resin is an epoxy resin curing agent, and novolak phenol resins such as phenolnovolak resin, phenolaralkyl resin, cresol novolak resin, tert-butylphenolnovolak resin, and nonylphenolnovolak resin; resole phenol resin; and polyoxystyrenes such as polyparaoxystyrene are used. These can be used singly, or can be used in combination of two or more.

Of these phenol resins, preferably, novolak resin, more preferably, phenolnovolak resin, phenolaralkyl resin, or even more preferably, phenolaralkyl resin is used. Containing these phenol resins allows for improvement in connection reliability of a soft magnetic film laminated circuit board produced by laminating the soft magnetic film on a circuit board.

When the hydroxyl equivalent of the phenol resin relative to 100 g/eq of the epoxy equivalent of the epoxy resin is 1 g/eq or more and less than 100 g/eq, the epoxy resin content relative to 100 parts by mass of the resin component is, for example, 15 parts by mass or more, preferably 30 parts by mass or more, and for example, 70 parts by mass or less, and the phenol resin content relative to 100 parts by mass of the resin component is, for example, 5 parts by mass or more, preferably 15 parts by mass or more, and for example, 30 parts by mass or less.

When the hydroxyl equivalent of the phenol resin relative to 100 g/eq of the epoxy equivalent of the epoxy resin is 100 g/eq or more and less than 200 g/eq, the epoxy resin content relative to 100 parts by mass of the resin component is, for example, 10 parts by mass or more, preferably 25 parts by mass or more, and for example, 50 parts by mass or less, and the phenol resin content relative to 100 parts by mass of the resin component is, for example, 10 parts by mass or more, preferably 25 parts by mass or more, and for example, 50 parts by mass or less.

When the hydroxyl equivalent of the phenol resin relative to 100 g/eq of the epoxy equivalent of the epoxy resin is 200 g/eq or more and 1000 g/eq or less, the epoxy resin content relative to 100 parts by mass of the resin component is, for example, 5 parts by mass or more, preferably 15 parts by mass or more, and for example, 30 parts by mass or less, and the phenol resin content relative to 100 parts by mass of the resin component is, for example, 15 parts by mass or more, preferably 35 parts by mass or more, and for example, 70 parts by mass or less.

When two types of epoxy resins are used in combination, the epoxy equivalent is an epoxy equivalent of the total epoxy resins calculated by multiplying the epoxy equivalent of each of the epoxy resins by the mass ratio of each of the epoxy resins relative to the total amount of the epoxy resins, and adding these.

The hydroxyl equivalent of the phenol resin per 1 equivalent of the epoxy group of the epoxy resin is, for example, 0.2 equivalent or more, preferably 0.5 equivalent or more, and for example, 2.0 equivalent or less, preferably 1.2 equivalent or less. When the amount of the hydroxyl group is within the above-described range, curing reaction of the soft magnetic film in semi-cured state will be excellent, and deterioration can be suppressed.

The resin component has a thermosetting resin content relative to 100 parts by mass of the resin component of, for example, 20 parts by mass or more, preferably 30 parts by mass or more, and for example, 90 parts by mass or less, preferably 80 parts by mass or less, more preferably 60 parts by mass or less.

The resin component contains, in addition to the thermosetting resin, acrylic resin. Acrylic resin, epoxy resin, and phenol resin are used in combination. The resin component containing these resins allows for production of a uniform and highly filled soft magnetic film without unevenness on lamination interface when a plurality of soft magnetic films in semi-cured state are laminated and heat-pressed to produce a sheet of soft magnetic film in cured state.

An example of the acrylic resin includes an acrylic polymer produced by polymerizing a monomer component of one, or two or more alkyl (meth)acrylates having a straight chain or branched alkyl group. The "(meth)acryl" represents "acryl and/or methacryl".

An example of the alkyl group includes an alkyl group having 1 to 20 carbon atoms such as methyl group, ethyl group, propyl group, isopropyl group, n-butyl group, t-butyl group, isobutyl group, amyl group, isoamyl group, hexyl group, heptyl group, cyclohexyl group, 2-ethylhexyl group, octyl group, isooctyl group, nonyl group, isononyl group, decyl group, isodecyl group, undecyl group, lauryl group, tridecyl group, tetradecyl group, stearyl group, octadecyl group, and dodecyl group. Preferably, an alkyl group having 1 to 6 carbon atoms is used.

The acrylic polymer can be a copolymer of alkyl (meth)acrylate and an additional monomer.

Examples of the additional monomer include glycidyl group-containing monomers such as glycidyl acrylate and glycidyl methacrylate; carboxyl group-containing monomers such as acrylic acid, methacrylic acid, carboxyethyl acrylate, carboxypentyl acrylate, itaconic acid, maleic acid, fumaric acid, and crotonic acid; acid anhydride monomers such as maleic anhydride and itaconic acid anhydride; hydroxyl group-containing monomers such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-(hydroxymethyl)cyclohexyl)methyl acrylate; sulfonic acid group-containing monomers such as styrenesulfonic acid, allylsulfonic acid, 2-(meth) acrylamide-2-methylpropanesulfonic acid, (meth)acrylamidepropanesulfonic acid, sulfopropyl (meth)acrylate, and (meth)acryloyloxynaphthalenesulfonic acid; phosphoric acid group-containing monomers such as 2-hydroxyethylacryloyl phosphate; styrene monomer; and acrylonitrile.

Among these, preferably, a glycidyl group-containing monomer, a carboxyl group-containing monomer, or a hydroxyl group-containing monomer is used. When the acrylic resin is a copolymer of alkyl (meth)acrylate and an additional monomer of these, that is, when the acrylic resin contains a glycidyl group, a carboxyl group, or a hydroxyl group, the heat resistance of the soft magnetic film is excellent.

When the acrylic resin is a copolymer of alkyl (meth)acrylate and an additional monomer, the mixing ratio (mass) of the additional monomer relative to the copolymer is preferably 40 mass% or less.

The acrylic resin has a weight-average molecular weight of, for example, $1 \times 10^5$ or more, preferably $3 \times 10^5$ or more, and for example, $1 \times 10^6$ or less. The weight-average molecular weight of the acrylic resin within this range allows for excellent adhesiveness and heat resistance of the soft magnetic film. The weight-average molecular weight is measured based on polystyrene standard calibration value by Gel Permeation Chromatography (GPC).

The acrylic resin has a glass transition temperature (Tg) of, for example, -30°C or more, preferably -20°C or more, and for example, 30°C or less, preferably 15°C or less. The acrylic resin with a glass transition temperature (Tg) of the above-described lower limit or more allows for excellent adhesiveness of the soft magnetic film in semi-cured state. Meanwhile, the acrylic resin with a glass transition temperature (Tg) of the above-described upper limit or less allows for excellent handleability of the soft magnetic film. The glass transition temperature is obtained by the maximum value of loss tangent (tan$\delta$) measured by using a dynamic viscoelasticity measuring apparatus (DMA, frequency 1 Hz, rising temperature speed 10°C/min).

When the resin component contains acrylic resin, the acrylic resin content relative to 100 parts by mass of the resin component is, for example, 10 parts by mass or more, preferably 20 parts by mass or more, more preferably 40 parts by mass or more, and for example, 80 parts by mass or less, preferably 70 parts by mass or less. The acrylic resin content within this range allows for excellent film-forming characteristics of the soft magnetic resin composition and adhesiveness of the soft magnetic film in semi-cured state.

The soft magnetic resin composition has a resin component content of, for example, 2 mass% or more, preferably 5 mass% or more, and for example, 50 mass% or less, preferably 20 mass% or less, more preferably 15 mass% or less. The resin component content within the above-described range allows for excellent film-forming characteristics of the soft magnetic resin composition.

The resin component can contain a resin other than the thermosetting resin and the acrylic resin. An example of the resin other than the thermosetting resin and the acrylic resin includes a thermoplastic resin. These examples of the resin other than the thermosetting resin and the acrylic resin can be used singly, or can be used in combination of two or more.

Examples of the thermoplastic resin include natural rubber, butyl rubber, isoprene rubber, chloroprene rubber, ethylene-vinyl acetate copolymer, polybutadiene resin, polycarbonate resin, thermoplastic polyimide resin, polyamide resin (6-nylon, 6,6-nylon, etc.), phenoxy resin, saturated polyester resin (PET, PBT, etc.), polyamide-imide resin, and fluorine resin.

The soft magnetic resin composition (and soft magnetic film) preferably contains a thermosetting catalyst.

The thermosetting catalyst is not limited as long as the catalyst accelerates curing of the thermosetting resin by heating, and for example, an imidazole compound, a triphenylphosphine compound, a triphenylborane compound, and an amino group-containing compound can be used. Preferably, an imidazole compound is used.

Examples of the imidazole compound include 2-phenylimidazole (trade name; 2PZ), 2-ethyl-4-methylimidazole (trade name; 2E4MZ), 2-methylimidazole (trade name; 2MZ), 2-undecylimidazole (trade name; C11Z), 2-phenyl-4,5-dihydroxymethylimidazole (trade name; 2-PHZ), 2-phenyl-1H-imidazole 4,5-dimethanol (trade name; 2PHZ-PW), and 2,4-diamino-6-(2'-methylimidazolyl (1)') ethyl-s-triazine-isocyanuric acid adduct (trade name; 2MAOK-PW) (the products with the trade names shown above are all manufactured by Shikoku Chemicals Corporation.).

The shape of the thermosetting catalyst includes spherical and ellipsoidal shapes.

These thermosetting catalysts can be used singly, or can be used in combination of two or more.

The mixing ratio of the thermosetting catalyst relative to 100 parts by mass of the resin component is, for example, 0.2 parts by mass or more, preferably 0.3 parts by mass or more, and for example, 5 parts by mass or less, preferably 2 parts by mass or less. When the mixing ratio of the thermosetting catalyst is the above-described upper limit or less, the soft magnetic resin composition can achieve excellent storage stability for a long period of time under room temperature. Meanwhile, when the mixing ratio of the thermosetting catalyst is the lower limit or more, the soft magnetic film in semi-cured state can be heated and cured at a low temperature for a short period of time, and a soft magnetic film in cured state can be produced efficiently.

The soft magnetic resin composition can further contain, as necessary, an additional additive. Examples of the additive include a commercially available or known cross-linking agent and inorganic filler.

The soft magnetic resin composition can be prepared by mixing the above-described components at the above-described mixing ratio.

2. Soft Magnetic Film

The soft magnetic film of the present invention is formed from the soft magnetic resin composition into a sheet.

The soft magnetic film can be produced from, for example, a preparation step in which a solution of a soft magnetic resin composition is prepared by dissolving or dispersing a soft magnetic resin composition in a solvent, a drying step in which the solution of the soft magnetic resin composition is applied on the surface of a release substrate and dried to produce a soft magnetic film in semi-cured state, and a heat-pressing step in which a plurality of soft magnetic films in semi-cured state are laminated and heat-pressed.

First, the soft magnetic resin composition is dissolved or dispersed in a solvent (preparation step). A solution of the soft magnetic resin composition is prepared in this manner.

Examples of the solvent include organic solvents including ketones such as acetone and methyl ethyl ketone (MEK); esters such as ethyl acetate; amides such as N,N-dimethylformamide; and ethers such as propylene glycol monomethyl ether. Examples of the solvent also include water, and water-based solvents such as alcohols including methanol, ethanol, propanol, and isopropanol.

The solution of the soft magnetic resin composition has a solid content amount of, for example, 5 mass% or more, preferably 10 mass% or more, and for example, 50 mass% or less, preferably 20 mass% or less.

The solution of the soft magnetic resin composition is prepared in this manner.

Then, the solution of the soft magnetic resin composition is applied on the surface of the release substrate and dried (drying step).

Examples of the release substrate include a separator and a core material.

Examples of the separator include a polyethylene terephthalate (PET) film, a polyethylene film, a polypropylene film, and paper. Surfaces of these are treated with, for example, a fluorine release agent, a long-chain alkylacrylate release agent, and a silicone release agent.

Examples of the core material include a plastic film (for example, polyimide film, polyester film, polyethylene terephthalate film, polyethylenenaphthalate film, polycarbonate film, etc.), a metal film (for example, aluminum foil etc.), a resin substrate reinforced with glass fiber or plastic-made nonwoven fiber, a silicon substrate, and a glass substrate.

The separator or the core material has an average thickness of, for example, 1 $\mu$m or more and 500 $\mu$m or less.

The application method is not particularly limited, and examples thereof include a doctor blade method, roll application, screen application, and gravure application.

The drying conditions are as follows: a drying temperature of, for example, 70°C or more and 160°C or less, and a drying time of, for example, 1 minute or more and 5 minutes or less.

A soft magnetic film in semi-cured state is produced in this manner.

The soft magnetic film is in semi-cured state (B-stage state) at room temperature (to be specific, 25°C), and is a soft magnetic adhesive film having excellent adhesiveness.

The soft magnetic film (semi-cured state) has an average film thickness of, for example, 500 $\mu$m or less, preferably 300 $\mu$m or less, more preferably 200 $\mu$m or less, even more preferably, 150 $\mu$m or less, most preferably 100 $\mu$m or less, and for example, 5 $\mu$m or more, preferably 50 $\mu$m or more.

Then, a plurality of produced soft magnetic films in semi-cured state are prepared, and the plurality of soft magnetic films are heat-pressed with a heat press in a thickness direction (heat-pressing step). The soft magnetic films in semi-cured state (and soft magnetic composition) are cured by heating in this manner.

The heat-pressing can be performed by using a known press, and for example, a parallel plate press is used.

For example, two layers or more, and 20 layers or less, preferably 5 layers or less of the soft magnetic films (semi-cured state) are laminated. The soft magnetic film can be adjusted to have a desired film thickness in this manner.

The heating temperature is, for example, 80°C or more, preferably 100°C or more, and for example, 200°C or less, preferably 175°C or less.

The heating time is, for example, 0.1 hours or more, preferably 0.2 hours or more, and for example, 24 hours or less, preferably 3 hours or less, more preferably 2 hours or less.

The pressure is, for example, 10 MPa or more, preferably 20 MPa or more, and for example, 500 MPa or less, preferably 200 MPa or less. In this manner, the soft magnetic film highly filled with the soft magnetic particles, and the thin soft magnetic film can be achieved more excellently.

In this manner, the soft magnetic film in semi-cured state is cured by heating, thereby producing a soft magnetic film in cured state (C-stage state).

The soft magnetic film has a film thickness of, for example, 5 $\mu$m or more, preferably 50 $\mu$m or more, and for example, 500 $\mu$m or less, preferably 250 $\mu$m or less.

The filling rate of the soft magnetic particles (volume percentage, excluding gaps, of the soft magnetic particles accounting for the solid content in the soft magnetic film) relative to the solid content of the soft magnetic film is, for example, 55% by volume or more, preferably 58% by volume or more, even more preferably 60% by volume or more, and for example, 95% by volume or less, preferably 90% by volume or less. This allows for excellent relative magnetic permeability of the soft magnetic film. The filling rate of the soft magnetic particles in the soft magnetic film can be, for example, measured by the Archimedes method.

In the soft magnetic film, the soft magnetic particles contained in the soft magnetic film are preferably arranged in a 2-dementional in-plane direction of the soft magnetic film. That is, a longitudinal direction (direction perpendicular to thickness direction) of the flat soft magnetic particles is oriented to be along a surface direction of the soft magnetic film. Thus, the soft magnetic film is a thin film and has excellent relative magnetic permeability.

The soft magnetic film has a relative magnetic permeability of, for example, 150 or more, preferably 180 or more, more preferably 200 or more.

The soft magnetic film can be, for example, a single layer structure composed only of a single layer of the soft magnetic film, a multiple layer structure in which the soft magnetic film is laminated on one side or both sides of the core material, or a multiple layer structure in which a separator is laminated on one side or both sides of the soft magnetic film.

Although the plurality of soft magnetic films in semi-cured state are laminated and heat-pressed in the above-described embodiment, for example, the heat-pressing can be performed on a single soft magnetic film in semi-cured state (single layer).

Furthermore, although the soft magnetic film in semi-cured state is heat-pressed in the above-described embodiment, the heat-pressing does not have to be performed. That is, the soft magnetic film can be used as it is in semi-cured state. The surface of the soft magnetic film in semi-cured state is adhesive, and therefore, can be directly laminated on a circuit board, for example, without using an adhesive. Thereafter, as necessary, curing by heating can be performed to produce a soft magnetic film in cured state.

The soft magnetic film can be preferably used as a soft magnetic film (magnetic film) to be laminated on, for example, an antenna, a coil, or a circuit board having these formed on the surface thereof. To be more specific, the soft magnetic film can be used for intended uses such as smartphones, personal computers, and position detection devices.

Examples of a method for laminating the soft magnetic film on the circuit board include a method in which the soft magnetic film in cured state is fixed to the circuit board via an adhesive layer and a method in which after the soft magnetic film in semi-cured state is directly attached to the circuit board, the soft magnetic film in semi-cured state is cured by heating to be fixed to the circuit board.

In view of unnecessity of an adhesive layer and miniaturization of an electronic device, preferably, a method in which after the soft magnetic film in semi-cured state is directly attached to the circuit board, the soft magnetic film is cured by heating is used.

In view of insulation properties, preferably, a method in which the soft magnetic film in cured state is fixed to the circuit board via an adhesive layer is used.

As the adhesive layer, a known adhesive layer usually used as an adhesive layer of a circuit board is used. The adhesive layer is, for example, formed by applying adhesives such as an epoxy adhesive, a polyimide adhesive, and an acrylic adhesive to be dried. The adhesive layer has a thickness of, for example, 10 to 100 $\mu$m.

The soft magnetic resin composition contains the flat soft magnetic particles and the resin component, and the soft magnetic particles have a tap density of 1.1 $g/cm^3$ or less. Therefore, the soft magnetic film produced from the soft magnetic resin composition can contain the flat soft magnetic particles with a high filling rate.

It has been considered that use of soft magnetic particles having a high tap density, for example, soft magnetic particles having a large aspect ratio usually enables production of a soft magnetic film with a higher filling rate. However, it has been found that production of a soft magnetic film by using the soft magnetic resin composition containing the flat soft magnetic particles having a tap density of 1.1 $g/cm^3$ or less can unexpectedly reduce bubbles in the soft magnetic film. That is, a difference (divergence) between the volume content (charged filler content) of the soft magnetic particles in the soft magnetic resin composition and that of the soft magnetic particles in the produced soft magnetic film can be reduced. The produced soft magnetic film can contain the soft magnetic particles with a high filling rate.

This is presumably because use of the soft magnetic particles having a predetermined small tap density reduces the number of soft magnetic particles per unit weight, so that an easy and secure discharge path of the bubbles in the soft magnetic film can be achieved at the time of production of the soft magnetic film and the bubbles can be further more surely discharged at the time of press molding or the like.

The soft magnetic film contains the soft magnetic particles with a high filling rate, so that relative magnetic permeability is excellent. Furthermore, the flat soft magnetic particles are arranged in the 2-demential in-plane direction of the soft magnetic film, so that a thin soft magnetic film can be achieved.

In the soft magnetic film, excellent relative magnetic permeability can be achieved without necessitating surface treatment to the soft magnetic particles.

Examples

In the following, the present invention will be described in detail with Examples and Comparative Examples, but the present invention is not limited thereto. Values in Examples shown below can be replaced with the values described in the embodiments above (that is, upper limit value or lower limit value).

Example 1

(Soft Magnetic Particles)

Sendust (Fe-Si-Al alloy, trade name "SP-7", flat, true specific gravity 6.8 g/cm$^3$, manufactured by MATE CO., LTD.) was used for flat soft magnetic particles. Using a dry classifier (manufactured by NISSHIN ENGINEERING INC., turbo classifier TC-15NS), air was blown onto the soft magnetic particles under conditions of a rotational speed of a rotational vane of 2090 rpm and an air flow rate of 1.3 m$^3$/min, thereby producing soft magnetic particles having a tap density of 1.0 g/cm$^3$.
The tap density of the soft magnetic particles was obtained by using a tap density flowability and adhesion measuring apparatus ("Tap Denser KYT-4000", manufactured by SEISHIN ENTERPRISE Co., Ltd.).
Then, the average particle size $D_{50}$ of the soft magnetic particles was measured using a laser diffraction particle size distribution analyzer (manufactured by Sympatec, HELOS & RODOS). Table 1 shows the results.

(Soft Magnetic Film)

Then, 1150 parts by mass (92 mass%) of the soft magnetic particles obtained as described above, 50 parts by mass of acrylate ester polymer, 20 parts by mass of bisphenol A epoxy resin (1), 12 parts by mass of bisphenol A epoxy resin (2), 18 parts by mass of phenol aralkyl resin, and 0.5 parts by mass of thermosetting catalyst were mixed so that the soft magnetic particle content (charged filler content: sold content) in the soft magnetic resin composition (charged filler content) was 65% by volume, thereby producing a soft magnetic resin composition.
The soft magnetic resin composition was dissolved in methyl ethyl ketone, thereby preparing a solution of the soft magnetic resin composition having a solid content concentration of 12 mass%.
The solution of the soft magnetic resin composition was applied using an applicator on a separator (average thickness 50 μm) composed of a polyethylene terephthalate film to which silicone release treatment was given, and thereafter, dried at 130°C for 2 minutes.
In this manner, a soft magnetic film in semi-cured state on which a separator was laminated (average thickness of only soft magnetic film 35 μm) was produced.
Two soft magnetic films (semi-cured state) were produced, and these soft magnetic films (excluding separators) were laminated. The two laminated soft magnetic films were heat-pressed at 100 MPa and 175°C for 30 minutes, thereby producing a soft magnetic film (cured state) having a thickness of 60 μm.

Example 2

Classification was performed in the same manner as in Example 1, except that conditions of the dry classifier were changed to a rotational speed of a rotational vane of 1650 rpm and an air flow rate of 1.5 m$^3$/min, thereby producing soft magnetic particles having a tap density of 0.9 g/cm$^3$.
A soft magnetic film was produced in the same manner as in Example 1, except that the soft magnetic particles were used. Table 1 shows the results.

Example 3

Classification was performed in the same manner as in Example 1, except that conditions of the dry classifier were changed to a rotational speed of a rotational vane of 1140 rpm and an air flow rate of 1.3 m$^3$/min, thereby producing soft magnetic particles having a tap density of 0.7 g/cm$^3$.
A soft magnetic film was produced in the same manner as in Example 1, except that the soft magnetic particles were used. Table 1 shows the results.

Example 4

A soft magnetic film was produced in the same manner as in Example 1, except that the mixing ratio of the soft magnetic particles was changed to 850 parts by mass (88 mass%) so that the soft magnetic particle content (charged filler content: sold content) in the soft magnetic resin composition (charged filler content) was 55% by volume in Example 1.

Example 5

A soft magnetic film was produced in the same manner as in Example 1, except that the mixing ratio of the soft magnetic particles was changed to 960 parts by mass (90 mass%) so that the soft magnetic particle content (charged filler content: sold content) in the soft magnetic resin composition (charged filler content) was 58% by volume in Example 3.

Example 6

Classification was performed in the same manner as in Example 1, except that Sendust (Fe-Si-Al alloy, trade name "FME3DH", flat, true specific gravity 6.8 g/cm$^3$, manufactured by SANYO SPECIAL STEEL Co., Ltd.) was used for the flat soft magnetic particles and conditions of the dry classifier were changed to a rotational speed of a rotational vane of 2900 rpm and an air flow rate of 1.4 m$^3$/min, thereby producing soft magnetic particles having a tap density of 0.8 g/cm$^3$.
A soft magnetic film was produced in the same manner as in Example 1, except that the mixing ratio of the soft magnetic particles was changed to 960 parts by mass (90 mass%) so that the soft magnetic particle content (charged filler content: sold content) in the soft magnetic resin composition (charged filler content) was 58% by volume by using the soft magnetic particles.

Example 7

Classification was performed in the same manner as in Example 6, except that conditions of the dry classifier were changed to a rotational speed of a rotational vane of 2750 rpm and an air flow rate of 1.3 m$^3$/min, thereby producing soft magnetic particles having a tap density of 0.6 g/cm$^3$.
A soft magnetic film was produced in the same manner as in Example 6, except that the soft magnetic particles were used.

Comparative Example 1

Classification was performed in the same manner as in Example 1, except that conditions of the dry classifier were changed to a rotational speed of a rotational vane of 1000 rpm and an air flow rate of 1.3 m$^3$/min, thereby producing soft magnetic particles having a tap density of 1.3 g/cm$^3$.
A soft magnetic film was produced in the same manner as in Example 1, except that the soft magnetic particles were used. Table 1 shows the results.

Comparative Example 2

Classification was performed in the same manner as in Example 1, except that conditions of the dry classifier were changed to a rotational speed of a rotational vane of 800 rpm and an air flow rate of 1.3 m$^3$/min, thereby producing soft magnetic particles having a tap density of 1.7 g/cm$^3$.
A soft magnetic film was produced in the same manner as in Example 1, except that the mixing ratio of the soft magnetic particles was changed to 850 parts by mass (88 mass%) so that the soft magnetic particle content (charged filler content: sold content) in the soft magnetic resin composition (charged filler content) was 55% by volume by using the soft magnetic particles. Table 1 shows the results.

Comparative Example 3

Classification was performed in the same manner as in Example 1, except that conditions of the dry classifier were changed to a rotational speed of a rotational vane of 900 rpm and an air flow rate of 1.3 m$^3$/min, thereby producing soft magnetic particles having a tap density of 1.4 g/cm$^3$.
A soft magnetic film was produced in the same manner as in Example 1, except that the soft magnetic particles were used. Table 1 shows the results.

(Filling Rate)

The filling rate (volume percentage) of the soft magnetic films produced in Examples and Comparative Examples was determined. To be specific, the density of the produced soft magnetic film was measured using Archimedes' principle, and the measured density was used for calculation using the formula below. Table 1 shows the result.
[Mathematical Formula 1]

[Formula 1]

$$\text{(Filling rate)} = \frac{\text{(Measured Density)} - \text{(Resin Component Density)}}{\text{(Soft Magnetic Particle Density)} - \text{(Resin Component Density)}}$$

(Relative Magnetic Permeability)

The relative magnetic permeability of the soft magnetic films produced in Examples and Comparative Examples was measured by measuring an impedance using an impedance analyzer (manufactured by Agilent, product number "4294A"). Table 1 shows the results.

[Table 1]

[Table 1]

| | | Ex. 1 | Ex. 2 | Ex. 3 | Ex. 4 | Ex. 5 | Ex. 6 | Ex. 7 | Comp. Ex. 1 | Comp. Ex. 2 | Comp. Ex. 3 |
|---|---|---|---|---|---|---|---|---|---|---|---|
| Soft Magnetic Particles | Tap Density (g/cm$^3$) | 1.0 | 0.9 | 0.7 | 1.0 | 0.7 | 0.8 | 0.6 | 1.3 | 1.7 | 1.4 |
| | $D_{50}$ ($\mu$m) | 68 | 70 | 71 | 68 | 71 | 40 | 50 | 59 | 54 | 68 |
| Charged Filler Content (vol%) | | 65 | 65 | 65 | 55 | 58 | 58 | 58 | 65 | 55 | 65 |
| Filling Rate (vol%) | | 58 | 60 | 63 | 55 | 58 | 57 | 58 | 52 | 48 | 54 |
| Relative Magnetic Permeability | | 195 | 200 | 215 | 170 | 205 | 204 | 227 | 145 | 132 | 161 |

For the components in Examples and Comparative Examples, the following were used.

- Acrylate ester polymer: trade name "Paracron W-197CM", acrylate ester polymer mainly composed of ethyl acrylate-methyl methacrylate, manufactured by Negami Chemical Industrial Co., Ltd.

- Bisphenol A epoxy resin (1): trade name "Epikote 1004", epoxy equivalent 875 to 975 g/eq, manufactured by JER

- Bisphenol A epoxy resin (2): trade name "Epikote YL980", epoxy equivalent 180 to 190 g/eq, manufactured by JER

- Phenolaralkyl resin: trade name "MILEX XLC-4L", hydroxyl equivalent 170 g/eq, manufactured by Mitsui Chemicals, Inc.

- Thermosetting catalyst: trade name "CUREZOL 2-PHZ-PW", 2-phenyl-1H-imidazole 4,5-dimethanol, manufactured by Shikoku Chemicals Corporation

While the illustrative embodiments of the present invention are provided in the above description, such is for illustrative purpose only and it is not to be construed as limiting the scope of the present invention.

Industrial Applicability

The soft magnetic resin composition and the soft magnetic film of the present invention can be applied in various industrial products and, for example, can be used for position detection devices such as smartphones, tablet computers, and digitizers.

**Claims**

1.  A soft magnetic resin composition comprising:

    flat soft magnetic particles and a resin component, wherein
    the soft magnetic particles have a tap density of 1.1 g/cm$^3$ or less,
    the resin component contains epoxy resin, phenol resin, and acrylic resin, and
    the phenol resin is at least one kind selected from a group consisting of novolak phenol resin, resole phenol resin, and polyoxystyrene.

2.  The soft magnetic resin composition according to claim 1, wherein
    the soft magnetic particle content in the soft magnetic resin composition is 55% by volume or more and
    the soft magnetic resin composition characterizes the entire solid content including soft magnetic particles, resin component, thermosetting catalyst and optionally present additional additives, but not solvent.

3.  A soft magnetic film formed from a soft magnetic resin composition comprising:

    flat soft magnetic particles and a resin component, wherein
    the soft magnetic particles have a tap density of 1.1 g/cm$^3$ or less,
    the resin component contains epoxy resin, phenol resin, and an acrylic resin, and
    the phenol resin is at least one kind selected from a group consisting of novolak phenol resin, resole phenol resin, and polyoxystyrene.

4.  The soft magnetic film according to claim 3 produced by curing the soft magnetic resin composition by heating.

**Patentansprüche**

1.  Weichmagnetische Harzzusammensetzung, umfassend:

    flache weichmagnetische Teilchen und eine Harzkomponente,
    wobei
    die weichmagnetischen Teilchen eine Klopfdichte von 1,1 g/cm$^3$ oder weniger aufweisen,
    die Harzkomponente Epoxidharz, Phenolharz und Acrylharz enthält, und
    das Phenolharz mindestens eine Art ist, ausgewählt aus der Gruppe bestehend aus Novolak-Phenolharz, Resol-Phenolharz und Polyoxystyrol.

2.  Weichmagnetische Harzzusammensetzung gemäß Anspruch 1, wobei
    der weichmagnetische Teilchengehalt in der weichmagnetischen Harzzusammensetzung 55 Volumen-% oder mehr beträgt und
    die weichmagnetische Harzzusammensetzung den gesamten Feststoffgehalt, der weichmagnetische Teilchen, Harzkomponente, Wärmehärtungskatalysator und optional gegenwärtige zusätzliche Additive, aber kein Lösungsmittel einschließt, kennzeichnet.

3.  Weichmagnetischer Film, der aus einer weichmagnetischen Harzzusammensetzung gebildet ist, die folgendes umfasst:

    flache weichmagnetische Teilchen und eine Harzkomponente,
    wobei
    die weichmagnetischen Teilchen eine Klopfdichte von 1,1 g/cm$^3$ oder weniger aufweisen,
    die Harzkomponente Epoxidharz, Phenolharz und Acrylharz enthält, und
    das Phenolharz mindestens eine Art ist, ausgewählt aus der Gruppe bestehend aus Novolak-Phenolharz, Resol-Phenolharz und Polyoxystyrol.

4.  Weichmagnetischer Film gemäß Anspruch 3, der durch Härten der weichmagnetischen Harzzusammensetzung durch Erwärmen hergestellt ist.

**Revendications**

1.  Composition de résine magnétique douce comprenant :

    des particules magnétiques douces et un composant de résine,
    dans laquelle
    les particules magnétiques douces ont une densité tassée de 1,1 g/cm$^3$ ou moins,
    le composant de résine contient une résine époxy, une résine phénol, et une résine acrylique, et
    la résine phénol est au moins d'une sorte choisie parmi un groupe constitué d'une résine phénol novolak, une
    résine phénol résol, et un polyoxystyrène.

2.  La composition de résine magnétique douce selon la revendication 1, dans laquelle
    la tenue en particules magnétiques douces dans la composition de résine magnétique douce est de 55% en volume
    ou plus et
    la composition de résine magnétique douce caractérise la teneur en solide entière comportant des particules magnétiques douces, le composant de résine, le catalyseur thermodurcissable et des additifs additionnels optionnellement présents, mais pas de solvant.

3.  Film magnétique doux formé d'une composition de résine magnétique douce comprenant :

    des particules magnétiques douces plates et un composant de résine, dans laquelle
    les particules magnétiques douces ont une densité tassée de 1,1 g/cm$^3$ ou moins,
    le composant de résine contient une résine époxy, une résine phénol, et une résine acrylique, et
    la résine phénol est au moins d'une sorte choisie parmi un groupe constitué d'une résine phénol novolak, une
    résine phénol résol, et un polyoxystyrène.

4.  Le film magnétique doux selon la revendication 3 produit en durcissant la composition de résine magnétique douce
    en chauffant.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006039947 A
- JP 2005310952 A
- JP 2009059753 A